# EUROPÄISCHE PATENTSCHRIFT

(11) **EP 1 100 301 B1**
(45) Veröffentlichungstag und Bekanntmachung des Hinweises auf die Patenterteilung: **05.02.2003**
(21) Anmeldenummer: 99122491.6
(22) Anmeldetag: 11.11.1999
(51) Int. Cl.: H05K 9/00

(54) **Hochfrequenzdichte Schirmung**
High frequency shielding
Blindage de haute fréquence

(43) Veröffentlichungstag der Anmeldung: 16.05.2001
(73) Patentinhaber: Kathrein-Werke KG, 83022 Rosenheim (DE)
(72) Erfinder: Fischer, Friedrich, 83737 Irschenberg (DE)
(74) Vertreter: Flach, Dieter Dipl.-Phys.

(56) Entgegenhaltungen:
- US-A- 1 765 443
- US-A- 5 814 762

## Beschreibung

Die Erfindung betrifft eine hochfrequenzdichte Schirmung für Gehäuse nach dem Oberbegriff des Anspruches 1.

In der Kommunikationstechnik allgemein, d.h. insbesondere auch in der Rundfunk- und Fernseh-Übertragungstechnik einschließlich der Satellitenübertragungen, kommt der frequenzdichten Schirmung von Geräten, Gehäusen, Boxen oder Cassetten eine wichtige Bedeutung zu. Dadurch soll verhindert werden, dass zum einen eine hochfrequente Strahlung aus dem zu schirmenden Gehäuse nach außen hin austritt oder aber durch im Umfeld vorhandene hochfrequente Strahlung eine unerwünschte Wechselwirkung mit den elektronischen Komponenten innerhalb des gesamten Gehäuses auftritt.

Häufigste Ursache von elektromagnetischen Störstrahlen ist die mangelnde Ausführung der Verbindung von Gehäuse und Deckelteilen. Kleine Spalten, die wie Schlitzantennen wirken, können die Schirmdämpfung erheblich verringern. Diese Spalten entstehen durch Toleranzen oder durch Unregelmäßigkeiten bzw. Unebenheiten der Gehäuse- oder Deckeloberfläche.

Verschmutzungen, Oxidschichten oder Korrosion der Oberfläche erhöhen zusätzlich den Übergangswiderstand der Kontaktstelle, was eine Verringerung der Schirmdämpfung zur Folge hat. Isolierende Lackschichten müssen grundsätzlich vor der Montage der Fügeteile entfernt werden.

Bei Schraub- oder Nietverbindungen verschlechtern zu geringe Vorspannkräfte und ein erhöhter Abstand der Verbindungselemente die Schirmwirkung. Große Teile der aufeinanderliegenden Flächen tragen infolge mangelnden Drucks und nicht ausreichenden ebenen Oberflächen nicht zu einer leitenden Verbindung bei.

Zum Ausgleich von Unregelmäßigkeiten an Deckel- bzw. Gehäuseoberflächen und zur Erzielung einer ausreichenden Schirmung sind bereits eine Reihe von Standarddichtungen entwickelt worden. Die bekannt gewordenen Hochfrequenz-Dichtungen (nachfolgend auch kurz HF-Dichtungen genannt) lassen sich in verschiedene Bereiche einteilen:
- CuBe Kontaktstreifen
- Vollmetallgewebeschnüre
- leitfähige Metallfolien, Abschirmbänder, Klebestreifen
- aufgespritzte leitfähige Silikonraupen
- leitfähige Silikone mit eingebetteten Drähten
- leitfähige Elastomere
- extrudierte leitende Silikondichtungen
- vulkanisierte leitfähige Dichtungen
- leitende Textildichtungen

Eine der üblichsten Formen ist dabei die Verwendung separater Kontakt-Schirmungselemente mit einer Vielzahl von Kontaktzungen, wie sie beispielsweise auch in der DE 43 40 198 C2 beschrieben sind. Derartige Schirmungselemete haben sich grundsätzlich bewehrt. Gemäß dieser Vorveröffentlichung wird vorgeschlagen, eine zu schirmende Abdeckung an ihrem Umlaufrand mit quer zum Umlaufrand vorstehenden Kontaktzungen zu versehen, die in entsprechende Aufnahmetaschen am Gehäuseteil, die durch Stege voneinander getrennt sind, eingesteckt werden, wobei der Abstand zwischen den Stegen geringfügig kleiner ist als die Quererstreckung der Kontaktzungen, so dass beim Einstecken der Kontaktzungen parallel zum Umlaufrand verlaufende Kräfte wirksam sind. Dabei sollen die Kontaktzungen im montierten Zustand entgegengesetzt zur Einsteckrichtung konkav durchgebogen sein.

Eine gattungsbildende hochfrequenzdichte Schirmung ist aus der US 5,814,762 bekannt geworden. Beispielsweise an einem Gehäusedeckel sind Kontaktierstellen ausgebildet, die mit den dazu kontaktierenden Wänden eines weiteren Gehäuseteiles die Schirmung bewirken soll. Diese kontaktierenden Elemente stehen aus der jeweiligen Ebene des sie tragenden Teiles vor. Sie können integrale Bestandteile beispielsweise eines Deckels oder als separate Teile daran befestigt sein. Wichtig ist gemäß dieser Vorveröffentlichung, dass diese die Schirmung bewirkenden Kontaktteile mit einer Spitze versehen sind, bevorzugt beispielsweise Pyramidenform aufweisen oder konisch gestaltet sind, so dass beim Zusammenfügen der zu kontaktierenden Teile die vorstehende Spitze sich in die Kontaktfläche des anderen Teils eingräbt, also eingedrückt wird, um hierdurch die gewünschte Kontaktierung zu bewirken.

Aufgabe der vorliegenden Erfindung ist es gegenüber dem Stand der Technik eine vereinfachte Lösung zu schaffen, die eine optimalere elektromagnetische Schirmwirkung für aneinander zu montierende schirmende Bauteile ermöglicht, insbesondere für ein mit einem Deckel versehenes Gehäuse.

Die Aufgabe wird erfindungsgemäß entsprechend den im Anspruch 1 angegebenen Merkmalen gelöst. Vorteilhafte Ausgestaltungen der Erfindung sind in den Unteransprüchen angegeben.

Die erfindungsgemäße elektromagnetische Schirmung zeichnet sich vor allem durch ihre Einfachheit aus. Erfindungsgemäß kann nämlich eine ausreichende elektromagnetische Schirmung allein dadurch erzielt werden, dass ein leitender Gehäusedeckel, in der Regel ein Blechdeckel, an den zu kontaktierenden Stellen, an denen am umlaufenden Rand eine Gehäusebox aufgesetzt wird, mit entsprechenden Prägungen in Richtung Gehäuse versehen wird. Da der Gehäusedeckel üblicherweise das Gehäuse selbst nicht oder praktisch nicht überragt, sitzen diese Gehäuseprägungen also am Deckelrand. Zwischen jeweils zwei umlaufend am Gehäuserand angreifenden Befestigungselementen ist zumindest eine oder sind beispielsweise zwei nebeneinandersitzende Prägungen ausgebildet. Vorzugsweise ist aber zwischen zwei Befestigungselementen stets nur eine Prägung vorgesehen. Die Befestigungselemente bestehen dabei bevorzugt aus dem Deckel bzw. den Deckelrand durchsetzenden Schrauben, die mit ihrem Gewindeabschnitt in entsprechende Gewindebohrungen am Gehäusewandabschnitt eingreifen.

Dadurch lässt sich sicher und eindeutig zumindest eine zusätzliche Kontaktstelle zwischen zwei Schraubelementen gewährleisten, da beim Verschrauben des Deckels die jeweils zumindest zwischen zwei Schrauben ausgebildete eine Prägung gegen die Stirnseite der Gehäusewandungen gedrückt wird und dabei einen ausreichend hohen Anpreßdruck erzeugt, mit der die Prägung am Stirnwandabschnitt des Gehäuses anliegt. Eine unerwünschte Schlitzbildung zwischen Deckel und Gehäuse wird reduziert.

Darüber hinaus ergibt sich aber auch ein zusätzlicher Effekt. Die überdehnten Prägungen bilden nämlich, was durchaus überraschend ist, nicht einen einzelnen Kontaktpunkt, sondern zumindest zwei in der Breite ausgedehnte Kontaktstellen zwischen den Befestigungselementen, d.h. in der Regel den Schrauben, mit denen der Deckel am Gehäuse befestigt ist. Ein ansonsten im Stand der Technik entstehender möglicherweise auch nur geringer Abstandsspalt zwischen Deckelunterseite und den Stirnflächen der Gehäusewandungen wird dadurch zusätzlich verringert und die Schirmdämpfung erhöht.

Die Erfindung unterscheidet sich vom gattungsbildenden Stand der Technik also vor allem dadurch, dass die die Kontaktierung bewirkenden Erhebungen nicht als separate vollvolumige Teile ausgebildet sind, die beispielsweise auf dem Deckel angebracht sind, sondern dass in dem betreffenden Teil Prägungen eingebracht sind und diese eine zumindest leicht ballige Oberfläche aufweisen, also keine spitzen Erhebungen, die beim Kontaktieren mit einer Gegenfläche sich von daher auch nicht in diese Gegenfläche einkerben oder eingraben können. Es wird in Abweichung zum Stand der Technik also die Gegenfläche durch irgendwelche vorstehenden Spitzen oder Erhebungen weder verletzt noch verformt. Speziell durch diese Ausbildung der leicht ballig gestalteten Prägung ergibt sich die mehr als überraschende Möglichkeit, dass ebenfalls in Abweichung zum Stand der Technik eine Kontaktierung nicht nur immer an der Spitze eines vorstehenden Kontaktteils möglich ist, sondern dass sich durch die leicht ballig gestaltete Prägung gemäß der vorliegenden Erfindung mehrfach Kontaktstellen ausbilden können.

Durch die erfindungsgemäße Hochfrequenzschirmung lässt sich aber auch eine Abschirmung im Inneren von Hochfrequenzgehäusen wie die Trennung der Resonatorkammern von Duplexweichen etc. realisieren.

Die Erfindung wird nachfolgend anhand von Ausführungsbeispielen näher erläutert. Dabei zeigen im einzelnen
- Figur 1 :: in schematischer Darstellung ein schirmdichtes Gehäuse mit einer kastenförmigen Gehäusebasis und einem Deckel;
- Figur 2 :: eine schematische Draufsicht auf den Gehäusedeckel;
- Figur 3 :: eine schematische auszugsweise Seitendarstellung des Gehäuses;
- Figur 4 :: eine auszugsweise schematische vertikale Querschnittsdarstellung längs der Linie A-A in Figur 3;
- Figur 5 :: eine auszugsweise schematische Draufsicht auf den Gehäusedeckel;
- Figur 6 :: eine theoretische Untersuchung bezüglich der erfindungsgemäß erzeugten Kontaktstelle zwischen Deckel und Gehäusewandung;
- Figur 7 :: ein abgewandeltes Ausführungsbeispiel eines hochfrequenzdicht geschirmten Gehäuses in einer perspektivischen Darstellung bei abgenommenen Gehäusedeckel;
- Figur 8 :: eine Seitenansicht auf das Ausführungsbeispiel gemäß Figur 7 bei aufgeschraubten Gehäusedeckel;
- Figur 9 :: eine Draufsicht auf das Ausführungsbeispiel gemäß Figur 7 und 8 bei abgenommenen Gehäusedeckel; und
- Figur 10:: eine auszugsweise Schnittdarstellung längs der Linie A-A in Figur 9.

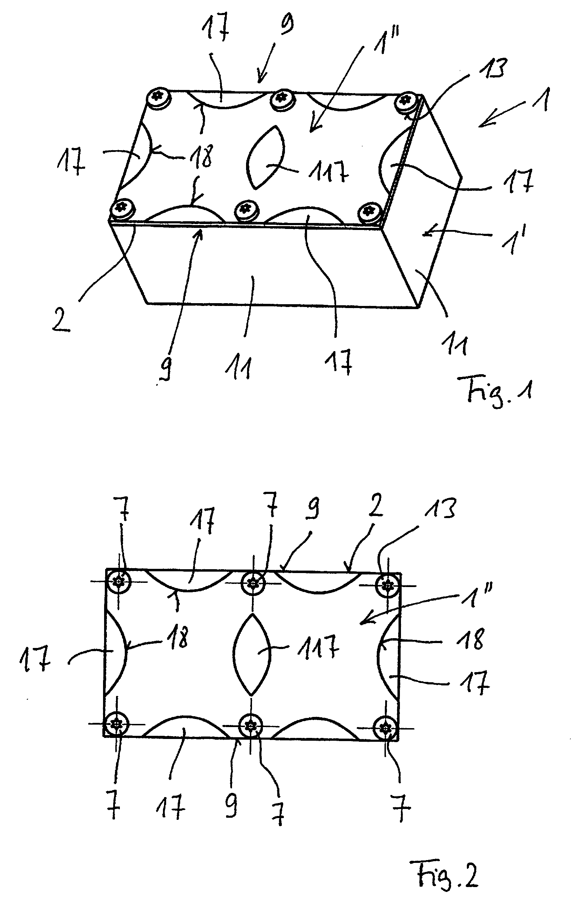

In Figur 1 ist in schematischer Darstellung ein geschirmtes Gehäuse 1 gezeigt, welches aus einem kastenförmigen Gehäuseteil 1' (teilweise nachfolgend auch als kastenförmiges Gehäuse unterteilt bezeichnet) und einem Deckel 1" besteht.

Das Gehäuse 1 ist üblicherweise aus einem eine elektromagnetischen Schirmung erzeugenden Metall oder einer Metallegierung aus gestanzten oder gefalzten Blechteilen oder aus Zinkdruckguß hergestellt oder beispielsweise im Rahmen der Frästechnik, durch die Tiefziehtechnik, durch die Gußtechnik, durch die Strangpreß- oder Profiltechnik.

Aus der schematischen Draufsicht auf den Deckel 1" gemäß Figur 2 ergibt sich, dass beispielsweise bei dem dort schematisch wiedergegebenen Gehäuse 1 der Deckel 1" unter Verwendung von vier in den Ecken sitzenden Schrauben 7 und durch zwei zusätzliche an den beiden Längsseiten 9 oberhalb der darunter befindlichen Gehäusewandungen 11 sitzenden Schrauben befestigbar ist, wozu in dem Deckel 1" entsprechende Bohrungen 13 ausgebildet sind, die beispielsweise mit darunter in den Gehäusewandungen 11 eingebrachten Bohrungen 15 fluchten, so dass die Schrauben 7 unter Durchsetzung der Bohrungen 13 in entsprechende Gewindebohrungen 15 in die Gehäusewandung 11 unter Festziehen des Deckels 1" eingedreht werden können.

Im gezeigten Ausführungsbeispiel ist jeweils zwischen zwei Schrauben 7 eine Prägung 17 in den Deckel 1" eingebracht, die in Draufsicht nach Art einer halben Ellipse ausgebildet ist. Die Prägelinie, an der der in der Regel ebene Deckel 1" in den vertieften Prägeabschnitt 17 übergeht, ist mit dem Bezugszeichen 18 benannt.

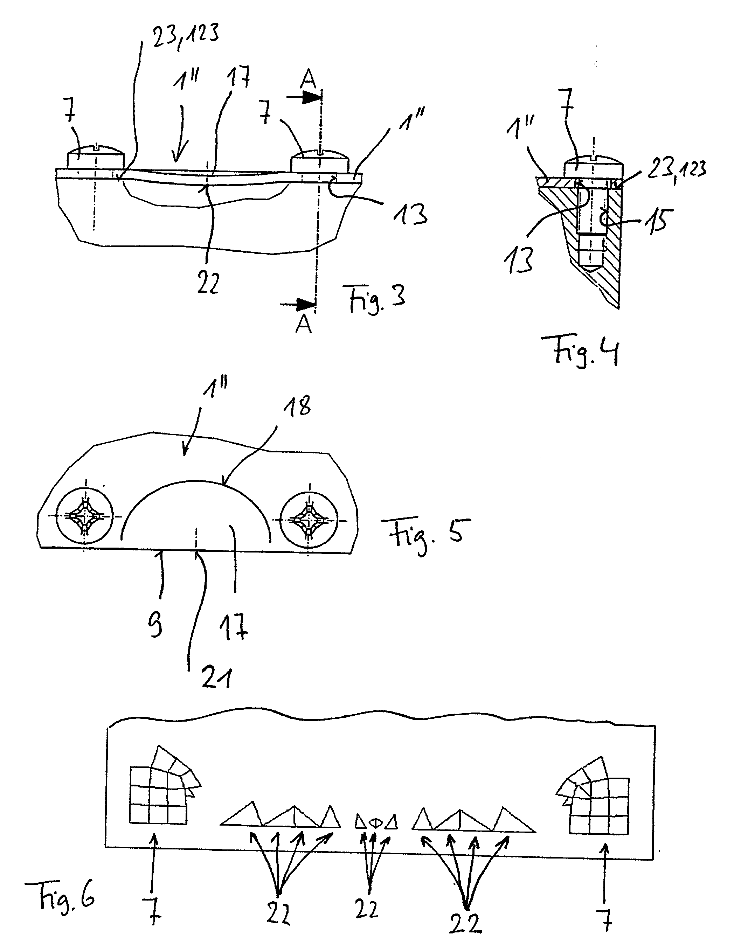

Wie sich insbesondere aus der Seitendarstellung gemäß Figur 3 und einer vergrößerten Detail-Draufsicht aus Figur 4 ergibt, ist die Prägung in Seitendarstellung in der Ebene des Deckels liegend leicht ballig gestaltet und weist in der Mitte 21 (am Deckelrand 9) ihren tiefsten Punkt auf. Abweichend von der elliptischen Gestaltung kann die Prägung auch eher teilkreis-, d.h. halbkreisförmig gestaltet sein, wie sich dies ansatzweise aus der Draufsicht gemäß Figur 4 ergibt.

Es wäre zu erwarten, dass am tiefsten Punkt der Ausprägung, d.h. in der Mitte 21 eine entsprechende Kontaktstelle 22 gebildet wird.

Wie sich aus der Finite-Elemente-Methode (nachfolgend kurz FEM-Berechnungsmethode genannt) unter Bezugnahme auf Figur 6 ergibt, wird aber nicht nur am tiefsten Punkt 22 der Ausprägung, d.h. in der Mitte 21 eine entsprechende Kontaktierung zwischen Deckel 1" und der oberen Stirnwand 23 der umlaufenden Gehäusewandung 11 erzeugt, sondern zumindest eine doppelte Kontaktierung. Die Stirnwand 23 dient also als Kontaktfläche 123, die mit den am anderen Bauteil, hier dem Deckel 1" ausgebildeten Prägungen 17 kontaktiert wird.

Anhand von Figur 6 ist dabei in Form von Dreiecken dargestellt, dass der Deckel zwischen jeweils zwei Schrauben 7 die Stirnwand 23 des kastenförmigen Gehäuses 1' mehrfach kontaktiert. Die Kontaktstellen zwischen Deckel 1" und der Oberseite 23, 123 der Gehäusewandung sind mit Bezugszeichen 22 gekennzeichnet. In Figur 6 sind dazu auch die auftretenden Kontaktkräfte dargestellt. Je höher die Dreiecke bezogen auf ihre Grundlinien sind, umso höher sind die Kontaktkräfte.

Die besten Ergebnisse werden dann erzielt, wenn zwischen zwei benachbarten Schrauben 7 nur eine Ausprägung mit einer am tiefsten liegenden Mitte 21 realisiert wird. Im Sinne der Erfindung können aber noch gute Ergebnisse dann erzielt werden, wenn beispielsweise zwei nebeneinandersitzende Ausprägungen 17 oder ineinander übergehende Ausprägungen mit zwei tiefsten Punkten 21 erzeugt werden, wobei auch hier eine Kontaktierung nicht nur an den beiden am tiefsten liegenden Mittelpunkten 21 zu der Gehäusewandung realisiert wird, sondern entsprechend der Darstellung gemäß Figur 6 zusätzliche nicht zu erwartende Kontaktpunkte erzeugt werden.

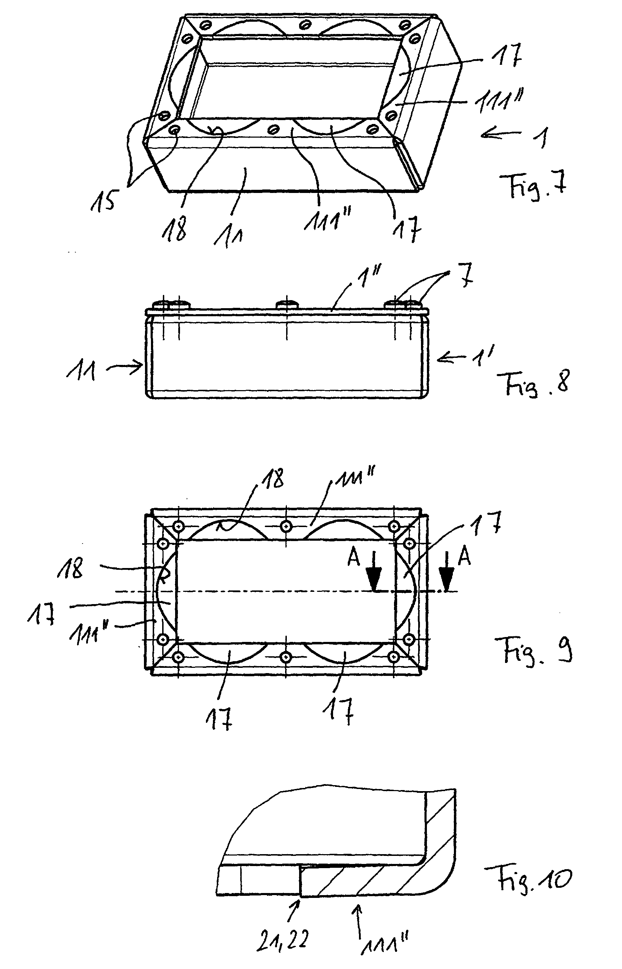

Anhand der Figuren 7 und 8 ist eine Abwandlung zu dem vorausgegangenen Ausführungsbeispiel erläutert, und zwar dergestalt, dass am oberen Ende der Gehäusewandung 11 ein beispielsweise nach innen verlaufender, d.h. sich horizontal und damit quer zur Gehäusewand 11 erstreckender Flanschabschnitt 111" vorgesehen ist, in welchem an den Prägelinien 18 beginnend die im vorstehenden Ausführungsbeispiel erläuterten Prägungen 17 eingebracht sind, und zwar in diesem Ausführungsbeispiel nach oben hin vorstehend. Die Prägungen 17 weisen aber in Anbaurichtung, d.h. in jene Richtung, von der der Deckel 1" aufgesetzt wird. In diesem Ausführungsbeispiel ist der Deckel 1" ohne Prägungen gestaltet. Eine feste Verbindung erfolgt hier ebenfalls wieder mittels Eindrehen von Schrauben 7 oder z.B. Nieten oder unter Verwendung anderer Befestigungstechniken.

Die im ersten Ausführungsbeispiel erläuterten Mehrfach-Kontaktpunkte 22 bilden sich bei diesem Ausführungsbeispiel gleichermaßen aus.

Mit anderen Worten wird eine verbesserte einfache Schirmung stets dadurch erzielt, dass zwei an einer Kontaktfläche hochfrequenzdicht zu schirmende Teile mittels einer Montage- oder Klemmeinrichtung vorzugsweise unter Verwendung von Schrauben verbunden werden, wobei zumindest ein Teil bevorzugt im Bereich zwischen den Schrauben mit zumindest einer in Richtung des anderen anzubauenden Teiles leicht vorstehenden Prägungen versehen ist.

Auch wenn anhand der erläuterten Ausführungsbeispiele von den Begriffen "Deckel" zum einen bzw. von "Gehäusewand" bzw. von einem "Flansch" zum anderen gesprochen wird, so wird von diesen Begriffen auch eine Ausführungsform erfaßt, bei welcher die hochfrequenzdichte Schirmung HF-dicht zu verbindende Bauteile nicht im eigentlichen Sinne als Deckel oder Gehäusewand bezeichnet werden.

Nur der Vollständigkeit halber wird noch darauf hingewiesen, dass beispielsweise bei dem Ausführungsbeispiel nach Figuren 1 und 2 in der Mitte des Deckels 1" oben liegend noch eine weitere Einprägung 117 vergleichbar den Einprägungen 17 vorgesehen ist, die von der Form und Größe her aus zwei halbelyptischen Einprägungen zusammengesetzt ist und dadurch die mandelförmige Form aufweist. Diese nach innen weisende Einprägung 117 kann mit einer darunter in der Box befindlichen Wand zusammenwirken, d.h. mit einer unterhalb der Prägung befindlichen Stirnseite einer Wand. Dadurch lässt sich eine Abschirmung im Inneren von Hochfrequenzgehäusen sowie die Trennung von Resonatorkammern von Duplexweichen etc. realisieren.

## Patentansprüche

1. Hochfrequenzdichte Schirmung, für mit einem Deckel (1") versehene Gehäuse (1'), **gekennzeichnet durch** die folgenden Merkmale,
- der Deckel (1") ist mittels einer Befestigungseinrichtung an Stirnwänden (23) der Gehäusewände (11) des Gehäuses (1) anbringbar, und
- zwischen zwei Befestigungsstellen zwischen dem Deckel (1") und den Gehäusewänden (11) ist zumindest ein am Deckel (1") oder an den Gehäusewänden (11) ausgebildeter eine schirmende Kontaktierung ermöglichender Vorsprung ausgebildet,
**gekennzeichnet durch** die folgenden weiteren Merkmale
- der kontaktierende Vorsprung besteht aus einer Prägung (17), und
- die leicht vorstehende Prägung (17) ist leicht ballig ausgebildet.

2. Schirmung nach Anspruch 1, **dadurch gekennzeichnet, dass** die Prägung am Deckel (1") in dem Bereich ausgebildet ist, unterhalb dessen die damit zu kontaktierende Gehäusewand (11), deren Stirnwand (23) bzw. ein daran ausgebildeter Flansch (25) zu liegen kommt.

3. Schirmung nach Anspruch 1, **dadurch gekennzeichnet, dass** die Prägung (17) an einer Gehäusewand (11) oder einem daran ausgebildeten Flanschabschnitt (25) ausgebildet und in Richtung der Kontaktfläche (123) an dem zweiten damit zu schirmenden Bauteil, d.h. dem Deckel (1") vorstehend ausgebildet ist.

4. Schirmung nach einem der Ansprüche 1 bis 3, **dadurch gekennzeichnet, dass** die Prägungen (17) am Deckel- und am Flanschrand (1"; 25) ausgebildet sind.

5. Schirmung nach einem der Ansprüche 1 bis 4, **dadurch gekennzeichnet, dass** die Prägung (17) in Draufsicht bogenförmig gestaltete Abschnitte umfasst.

6. Schirmung nach Anspruch 5, **dadurch gekennzeichnet, dass** die Prägung (17) in Draufsicht durch eine bogenförmige Kante (18) begrenzt ist.

7. Schirmung nach einem der Ansprüche 1 bis 6, **dadurch gekennzeichnet, dass** der gegenüber dem verbleibenden Deckel- oder Flanschabschnitt (1"; 25) mit der Prägung (17) versehene Abschnitt nach Art einer Teil-Ellipse oder eines Teil-Kreises, einer halben Ellipse bzw. eines Halbkreises ausgebildet ist.

8. Schirmung nach einem der Ansprüche 1 bis 7, **dadurch gekennzeichnet, dass** die größte Prägungshöhe weniger als 1 mm, vorzugsweise weniger als 0,5 mm beträgt.

9. Schirmung nach einem der Ansprüche 1 bis 8, **dadurch gekennzeichnet, dass** auch bei einer nur einen einzigen Kontaktpunkt (21) aufweisenden Prägung eine Mehrfachkontaktierung zwischen Deckel (1") und Gehäusewandung (11) erzeugt ist.

## Revendications

1. Blindage vis-à-vis des hautes fréquences pour des boîtiers (1') pourvus d'un couvercle (1"), **caractérisé par** les éléments suivants :
- le couvercle (1") est susceptible d'être agencé sur des faces frontales (23) des parois (11) du boîtier (1) au moyen d'un dispositif de fixation,
- entre deux emplacements de fixation entre le couvercle (1") et les parois de boîtier (11) est réalisée au moins une saillie prévue sur le couvercle (1") ou sur les parois de boîtier (11) et permettant une mise en contact de blindage,
**caractérisé par** les autres éléments suivants :
- la saillie de mise en contact est constituée par un estampage (17), et
- l'estampage (17) légèrement en saillie est réalisé légèrement bombé.

2. Blindage selon la revendication 1, **caractérisé en ce que** l'estampage sur le couvercle (1") est réalisé dans la zone au-dessous de laquelle vient se poser la paroi de boîtier (11) à mettre en contact, sa face frontale (23) ou une bride (25) réalisée sur celle-ci.

3. Blindage selon la revendication 1, **caractérisé en ce que** l'estampage (17) est réalisé sur une paroi de boîtier (11) ou sur un tronçon de bride (25) réalisé sur celle-ci et est prévu en saillie en direction de la surface de contact (123) sur le deuxième composant à blinder avec celle-ci, c'est-à-dire sur le couvercle (1").

4. Blindage selon l'une des revendications 1 à 3, **caractérisé en ce que** les estampages (17) sont réalisés sur le bord du couvercle et sur le bord de la bride (1" ; 25).

5. Blindage selon l'une des revendications 1 à 4, **caractérisé en ce que** l'estampage (17) comprend en vue de dessus des tronçons configurés en forme arquée.

6. Blindage selon la revendication 5, **caractérisé en ce que** l'estampage (17) est limité par une arête (18) en forme arquée en vue de dessus.

7. Blindage selon l'une des revendications 1 à 6, **caractérisé en ce que** le tronçon pourvu de l'estampage (17) par rapport au tronçon de couvercle ou de bride restant (1" ; 25) est réalisé à la manière d'une ellipse partielle ou d'un cercle partiel, d'une demi-ellipse ou d'un demi-cercle.

8. Blindage selon l'une des revendications 1 à 7, **caractérisé en ce que** la plus grande hauteur de l'estampage est inférieure à 1 mm, de préférence inférieure à 0,5 mm.

9. Blindage selon l'une des revendications 1 à 8, **caractérisé en ce que** même dans le cas d'un estampage présentant un seul point de contact (21), une mise en contact multiple est établie entre le couvercle (1") et la paroi de boîtier (11).

## Claims

1. High-frequency shielding, for housings (1') provided with a cover (1''), **characterized by** the following features,
- the cover (1'') is adapted for fitting by means of a fastening device on end walls (23) of the housing walls (11) of the housing (1), and
- between two fastening points between the cover (1'') and the housing walls (11) there is formed at least one projection that permits shielding contacting and is formed on the cover (1'') or on the housing walls (11),
**characterized by** the following further features
- the contacting projection comprises an embossment (17), and
- the slightly protruding embossment (17) is formed in a slightly convex manner.

2. Shielding according to Claim 1, **characterized in that** the embossment on the cover (1'') is formed in the region below which the housing wall (11) to be contacted by it, the end wall (23) of said housing wall or a flange (25) formed on it comes to lie.

3. Shielding according to Claim 1, **characterized in that** the embossment (17) is formed on a housing wall (11) or a flange portion (25) formed on the latter and is formed such that it protrudes in the direction of the contact area (123) on the second component to be shielded by it, i.e. the cover (1'').

4. Shielding according to one of Claims 1 to 3, **characterized in that** the embossments (17) are formed on the cover rim and on the flange rim (1''; 25).

5. Shielding according to one of Claims 1 to 4, **characterized in that** the embossment (17) comprises portions of an arcuate shape in plan view.

6. Shielding according to Claim 5, **characterized in that** the embossment (17) is bounded in plan view by an arcuate edge (18).

7. Shielding according to one of Claims 1 to 6, **characterized in that** the portion provided with the embossment (17) is formed with respect to the remaining cover or flange portion (1''; 25) in the manner of a partial ellipse or a partial circle, a half-ellipse or a half-circle.

8. Shielding according to one of Claims 1 to 7, **characterized in that** the greatest embossment height is less than 1 mm, preferably less than 0.5 mm.

9. Shielding according to one of Claims 1 to 8, **characterized in that**, even in the case of an embossment having only a single contact point (21), multiple contacting between the cover (1'') and the housing wall (11) is produced.
